(19) **Europäisches Patentamt / European Patent Office / Office européen des brevets**

(11) **EP 1 348 105 B1**

(12) **EUROPÄISCHE PATENTSCHRIFT**

(45) Veröffentlichungstag und Bekanntmachung des Hinweises auf die Patenterteilung:
**17.02.2010 Patentblatt 2010/07**

(21) Anmeldenummer: **01989364.3**

(22) Anmeldetag: **04.12.2001**

(51) Int Cl.:
*G01C 19/00* (2006.01)     *G01C 19/56* (2006.01)
*G01C 25/00* (2006.01)

(86) Internationale Anmeldenummer:
**PCT/DE2001/004561**

(87) Internationale Veröffentlichungsnummer:
**WO 2002/048649 (20.06.2002 Gazette 2002/25)**

(54) **VERFAHREN ZUM ABGLEICHEN DES PHASENREGELKREISES EINER ELEKTRONISCHEN AUSWERTUNGSVORRICHTUNG SOWIE EINE ELEKTRONISCHE AUSWERTUNGSVORRICHTUNG**

METHOD FOR ADJUSTING THE PHASE-LOCKING LOOP OF AN ELECTRONIC EVALUATION DEVICE AND CORRESPONDING ELECTRONIC EVALUATION DEVICE

PROCEDE DE COMPENSATION DU CIRCUIT D'ASSERVISSEMENT DE PHASE D'UN DISPOSITIF D'EVALUATION ELECTRONIQUE, ET DISPOSITIF D'EVALUATION ELECTRONIQUE Y RELATIF

(84) Benannte Vertragsstaaten:
**DE FR GB IT**

(30) Priorität: **14.12.2000 DE 10062347**

(43) Veröffentlichungstag der Anmeldung:
**01.10.2003 Patentblatt 2003/40**

(73) Patentinhaber: **ROBERT BOSCH GMBH**
**70442 Stuttgart (DE)**

(72) Erfinder:
- **SCHMID, Frank**
  **72587 Roemerstein (DE)**
- **MOHAUPT, Jens**
  **72124 Pliezhausen (DE)**
- **BAUER, Wolfram**
  **72074 Tuebingen (DE)**

(56) Entgegenhaltungen:
**US-A- 5 379 223     US-A- 5 600 064**
**US-A- 5 850 035     US-A- 6 067 858**

EP 1 348 105 B1

**Beschreibung**

Stand der Technik

Die vorliegende Erfindung betrifft ein Verfahren zum Abgleichen des Phasenregelkreises einer elektronischen Auswertungsvorrichtung bzw. eine elektronische Auswertungsvorrichtung nach dem Oberbegriff des betreffenden unabhängigen Patentanspruchs.

Drehratensensoren, die den Coriolis-Effekt nutzen (s.g. Coriolis Vibratory Gyros bzw. abgekürzt: CVGs), weisen eine oszillierende Masse (Sensorelement) und eine elektronische Auswertungsschaltung auf, anhand der die Auslenkung der oszillierenden Masse aufgrund der Einwirkung einer äußeren Drehrate auf den Sensor ermittelt wird. Die elektronische Auswertungsschaltung ist typischerweise mit einem Phasenregelkreis (phase-locked-loop; PLL) versehen, um Informationen über die Phasenlage von weg- und geschwindigkeitsproportionalen Signalen zu gewinnen. Ferner wird die Signalverarbeitung durch die PLL auf die Sensorantriebsfrequenz synchronisiert.

Für die Coriolis-Kraft $F_c$ gilt:

$$F_c = 2*m* (v \times \Omega)$$

m: Masse der bewegten Struktur
v: Geschwindigkeit der bewegten Struktur
$\Omega$: äußere Drehrate

Die Coriolis-Kraft $F_c$ verursacht an einem CVG eine Auslenkung $\Delta x$. Diese Auslenkung $\Delta x$ hat durch die mechanische Übertragungsfunktion x/F des CVGs dann eine Phasenverschiebung $\alpha$ erfahren, wenn die Güte des mechanischen Systems nicht hinreichend groß ist und der Frequenzabstand von Arbeitsfrequenz zu Resonanzfrequenz der Detektionsmode gering ist.

Um eine Drehrate messen zu können, muß dieses Signal mit einem phasenrichtigen, geschwindigkeitsproportionalen Signal v_prop demoduliert werden. CVG's weisen Störsignale auf, die nicht proportional zur Geschwindigkeit sind. Diese Störsignale sind vielmehr in Phase zum Weg, und sie sind unter Umständen sehr viel größer, als das eigentlich zu messende Drehratensignal RATE. Das Demodulationssignal v_prop, das aus der PLL gewonnen wird, muß daher ebenfalls um $\alpha$ phasenverschoben werden, um exakt die Drehrate zu ermitteln und nicht Anteile des Störsignales QUAD im Ausgangssignal zu haben.

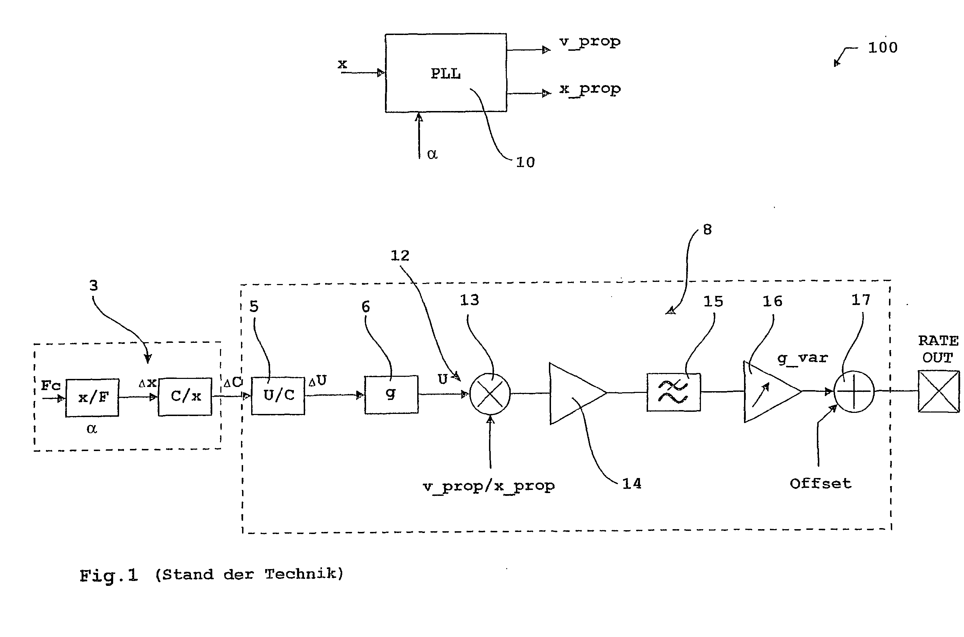

Um die PLL am Bandende abzugleichen, wird im Signalpfad nach QUAD (x_prop) demoduliert, die äußere Drehrate angelegt und die Phase solange verändert, bis am Signalausgang keine Auswirkung durch die Drehrate mehr zu sehen ist. Eine schaltungstechnische Realisation dieses Verfahren ist schematisch in Fig. 1 dargestellt.

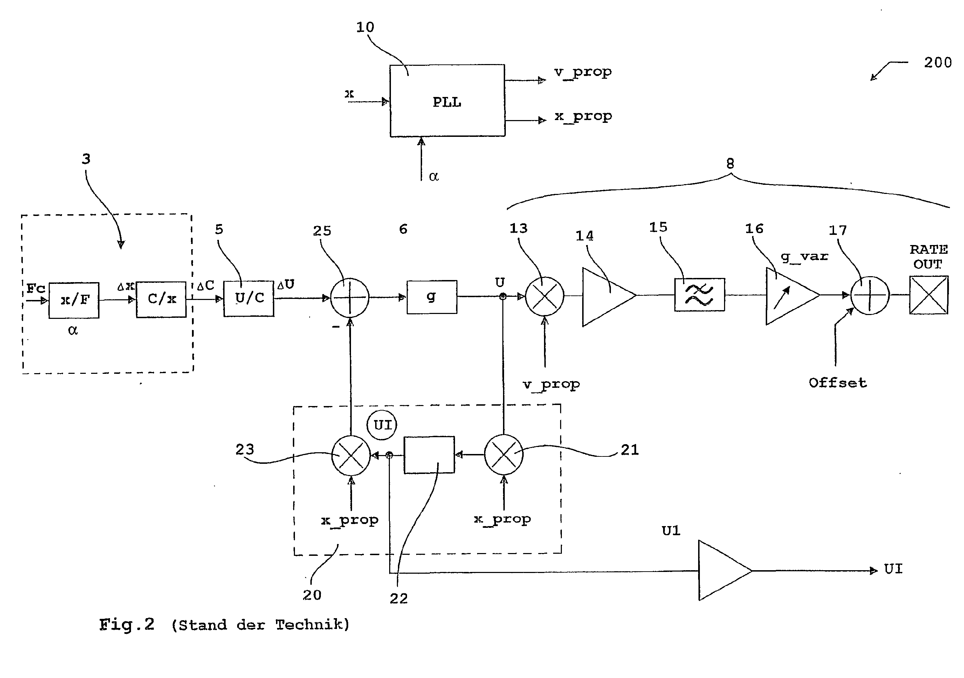

Diese Methode ist dann anwendbar, wenn die Quadratursignale so klein sind, daß sie den Signalpfad nicht übersteuern. Sind die Störsignale jedoch um mehrere Größenordnungen größer als das Nutzsignal, so muß ein Quadraturregelkreis vorgesehen werden. Dieses ist als Erweiterung der Darstellung von Fig. 1 in Fig. 2 zur Darstellung des Standes der Technik vorgenommen worden.

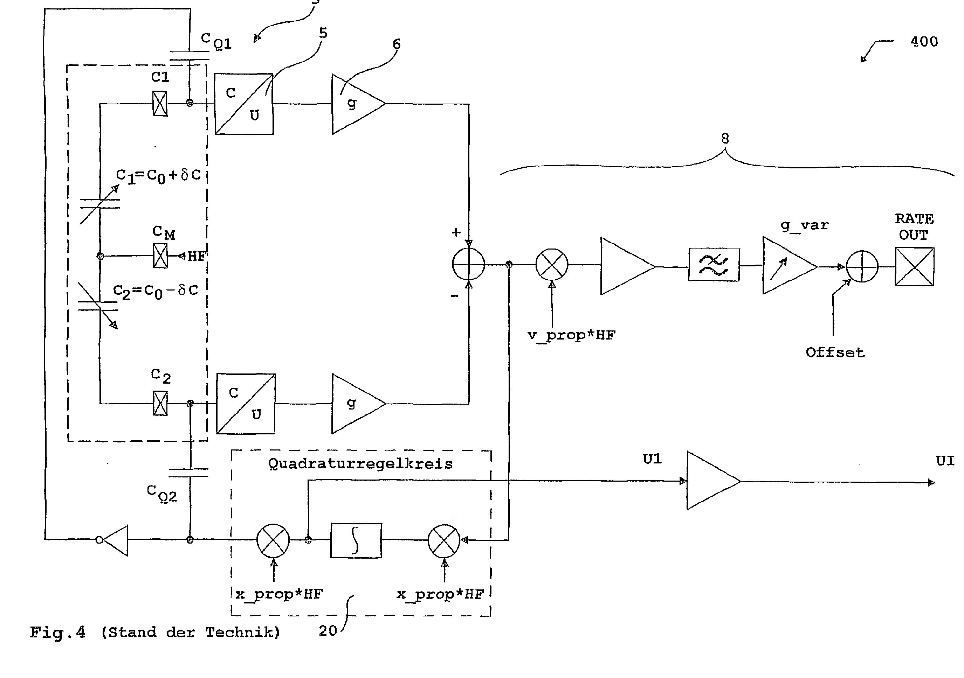

Das vorher beschriebene Abgleichverfahren versagt nun, da der Quadraturregelkreis bei angelegter Drehrate und einer fehlabgeglichenen PLL das nach Quadratur demodulierte Drehratensignal am Signalausgang unterdrückt, d. h. es fehlt das Kriterium zum Abgleichen der PLL. Vielmehr muß hier nun das Signal am Quadraturreglerausgang als Abgleichkriterium herangezogen werden. Am Ausgang des Quadraturreglers ergeben sich sehr kleine Signale in V/° ($\alpha$), die sich bei großem Fangbereich des Reglers weiter verkleinern. Diese Problematik kann nicht dadurch umgangen werden, daß das Reglerausgangssignal UI verstärkt ausgegeben wird (vgl. Fig. 2, Fig. 4), da die zur Verfügung stehende Versorgungsspannung meist begrenzt ist und z.B. 5V beträgt. Das zur Unterdrückung der Quadratur notwendige Signal ist oft wesentlich größer, als das durch Aufbringen einer Drehrate sich ergebende Signal. Das verstärkte Signal UI würde daher an die Grenzen des möglichen Aussteuerbereiches stoßen.

Die Druckschrift US 6,067,858 zeigt einen mikromechanischen Drehratensensor. Der Drehratensensor weist eine Auswerteschaltung mit einem Phasenregelkreis und eine Quadraturkompensation auf.

Die Druckschrift US 5,600,064 zeigt eine Elektronik für einen Coriolis-Kraftsensor. Die Elektronik weist ebenfalls eine Auswerteschaltung mit einem Phasenregelkreis und eine Schaltung zur Quadraturkompensation auf.

Vorteile der Erfindung

Die Aufgabe der vorliegenden Erfindung besteht in der Angabe eines Verfahrens zum Abgleichen des Phasenregelkreises einer elektronischen Auswertungsvorrichtung, die das Ausgangssignal einer Sensorvorrichtung auswertet, wie insbesondere ein den Coriolis-Effekt nutzender Drehratensensor sowie in der Angabe einer elektronischen Auswertungsvorrichtung, wobei das Verfahren bzw. die Auswertungsvorrichtung es ermöglicht den Phasenregelkreis der elektronischen Auswertungsvorrichtung bei einem deutlich-höheren Prozentsatz zugeordneter Sensorvorrichtungen abgleichen zu können.

Diese Aufgabe wird erfindungsgemäß durch ein Verfahren bzw. eine elektronische Auswertungsvorrichtung mit den Merkmalen der unabhängigen Patentansprüche gelöst. Vorteilhafte Ausgestaltungen der Erfindung sind in den Unteransprüchen angegeben.

Zur Unterdrückung von auslenkungsproportionalen Störsignalen ist in der Auswertungsvorrichtung zur Auswertung des Ausgangssignals einer Sensorvorrichtung ein Quadraturregelkreis notwendig, wie vorstehend bereits ausgeführt worden ist.

Ein wichtiger Aspekt der Erfindung besteht darin, den Quadraturregelkreis dahingehend zu erweitern, daß das Ausgangssignal des Reglers des Quadraturregelkreises während des Abgleichens des Phasenregelkreises im Vergleich zum normalen Regelbetrieb eine höhere Ausgangsspannung abgibt. Die abgegebene Ausgangsspannung ist abhängig von der Amplitude der auf die Sensorvorrichtung einwirkenden äußeren Drehrate und des in der PLL eingestellten Phasenwinkels $\alpha$. Dadurch kann der Fangbereich des Quadraturregelkreises für den normalen Regelbetrieb so dimensioniert werden, daß auch Sensorvorrichtungen mit großen Störamplituden verwendet werden können. Dies wäre ohne die erfindungsgemäße Veränderung des Regelkreises nicht möglich, da beide Anforderungen gegenläufig sind.

Wie ausgeführt, ist jeder Sensorvorrichtung eine elektronische Auswertungsvorrichtung zugeordnet, deren Phasenregelkreis auf die konkrete Sensorvorrichtung abgeglichen werden muß. Da die erfindungsgemäße elektronische Auswertungsvorrichtung bzw. das erfindungsgemäße Verfahren zum Abgleichen des Phasenregelkreises es erlaubt, auch Sensorvorrichtungen abgleichen zu können, deren Ausgangssignal ein höheres Störsignal aufweist, läßt sich der Ausschuß nicht abgleichbarer Sensorvorrichtungen und damit die Produktionskosten deutlich verringern.

Ferner ist von Vorteil, daß das erfindungsgemäße Verfahren zum Abgleichen des Phasenregelkreises bei sehr geringem schaltungstechnischen Aufwand vollständig automatisierbar und damit serientauglich ist.

Zeichnungen

Die Erfindung wird nachfolgend anhand eines Ausführungsbeispiels unter Verwendung eines bekannten mikromechanischen Drehratensensors, der eine oszillierende Masse aufweist, näher erläutert. Es zeigen in Form von schematischen Darstellungen:

Fig. 1    eine bekannte Auswertungsvorrichtung bzw. Auswertungsschaltung für den bekannten Drehratensensor, der in stark schematisierter Form dargestellt ist;

Fig. 2    eine bekannte Erweiterung der Auswertungsschaltung in Fig. 1 um einen Quadraturregelkreis zur Unterdrückung starker Störungen;

Fig. 3    eine erfindungsgemäße Auswertungsschaltung für den bekannten Drehratensensor, der in stark schematisierter Form dargestellt ist, wobei die Schalterstellungen erfindungsgemäßer Schalter für den normalen Reglerbetrieb dargestellt sind;

Fig. 3a   die erfindungsgemäße Auswertungsschaltung der Fig. 3, wobei die Schalterstellungen der erfindungsgemäßen Schalter für den Abgleichzustand dargestellt sind;

Fig. 4    den bekannten Drehratensensor in detaillierterer Darstellung und die bekannte Auswertungsschaltung gemäß Fig. 2; und

Fig. 5    den bekannten Drehratensensor in detaillierterer Darstellung und die erfindungsgemäße Auswertungsschaltung gemäß Fig. 3.

Ein CVG weist einen Antriebskreis auf, der dazu dient, eine seismische Masse in Schwingung zu versetzen. Ein im Antriebskreis abgegriffenes, elektrisches, wegproportionales Signal x dient als Eingangssignal für eine PLL. Je nach Antriebskonzept kann auch ein geschwindigkeitsproportionales Signal v verarbeitet werden. Auf die Darstellung des Antriebskreises ist im Rahmen der Beschreibung der vorliegenden Erfindung verzichtet worden, da sich die Erfindung auf die Verarbeitung der Ausgangssignale eines CVG bezieht.

Fig. 1 zeigt eine Kombination 100 eines bekannten Drehratensensors 3, der in stark schematisierter Form dargestellt ist, und einer bekannten Auswertungsvorrichtung bzw. Auswertungsschaltung 8, wobei die Auswertungsvorrichtung die Drehrate RATE OUT aus dem Ausgangssignal der Sensorvorrichtung bzw. des Drehratensensors bzw. des CVG 3 ermittelt. Die drehratenproportionale Coriolis-Kraft $F_c$ verursacht an der oszillierenden Masse eine Auslenkung $\Delta x$, die durch die mechanische Übertragungsfunktion x/F des betreffenden CVGs 3 eine Phasenverschiebung $\alpha$ gegenüber der Coriolis-Kraft $F_c$ erfahren hat. Nach dem Durchlaufen eines C/U-Wandlers 5 steht das Ausgangssignal des CVGs als Spannungssignal an und wird nach dem Durchlaufen eines Zwischenverstärkers 6 mit einem Verstärkungsfaktor g in der Auswertungsvorrichtung 8 als Spannung U weiterverarbeitet.

Um eine Drehrate RATE messen zu können, muß das Signal U mit einem phasenrichtigen, geschwindigkeitsproportionalen Signal demoduliert werden. Die hierzu verwendeten rechteckförmigen Signale x_prop und v_prop werden separat von einer Phasenregelschleife bzw. PLL 10 aus den Eingangssignalen x und $\alpha$ bereitgestellt. x_prop ist dabei in Phase mit dem Signal x. v_prop ist 90° phasenverschoben zu dem Signal x. Die Signale sind für phasenrichtige Synchrondemodulationen erforderlich. Ein CVG weist in der Regel Störsignale QUAD auf, die nicht proportional zur Geschwindigkeit, sondern vielmehr proportional und in Phase zum Weg sind. Zudem sind die Störsignale unter Umständen sehr viel größer, als das eigentlich zu messende Drehratensignal RATE OUT. Das Demodulationssignal v_prop, das aus der PLL 10 gewonnen wird, muß daher ebenfalls um $\alpha$ phasenverschoben werden, um die Drehrate RATE OUT exakt ermitteln zu können und um Anteile des Quadratursignales bzw. Störsignales QUAD im Ausgangssignal zu verhindern. Zur Ermittlung von $\alpha$ wird das Eingangssignal U der Auswertungsvorrichtung 8 in einem Signalpfad 12 nach QUAD (x_prop) demoduliert, indem es aufeinander folgend einem Mischer bzw. Multiplizierer 13, einem Verstärker 14, einem Tiefpaßfilter 15 und einem Verstärker 16 mit einstellbarer Verstärkung g_var zugeführt wird. An einem Summierer 17 wird ein Offset-Abgleich durchgeführt, so daß an einem Ausgang OUT das Quadratursignal QUAD als Signal abgegriffen werden kann.

Zur Einstellung bzw. zum Abgleich der dargestellten Vorrichtung wird an dem beschriebenen Signalpfad 12 das verstärkte Drehratensignal U des Drehratensensors 3 angelegt und der Phasenwinkel $\alpha$ solange verändert, bis am Signalausgang keine Auswirkung durch die Drehrate mehr erkennbar ist. Diese Methode ist aber nur dann anwendbar, wenn die Quadratursignale QUAD so klein sind, daß sie den Signalpfad 12 nicht übersteuern. Sind die Störsignale QUAD jedoch um mehrere Größenordnungen größer als das enthaltene und zu isolierende Drehratensignal RATE OUT, so muß ein Quadraturregelkreis 20 vorgesehen werden. Dieses ist als Erweiterung der Darstellung von Fig. 1 in der Schaltung von Fig. 2 vorgenommen worden. Der Quadraturregelkreis 20 umfaßt einen ersten Mischer 21, in dem das um den Faktor g durch den Verstärker 6 verstärkte Signal U mit x_prop gemischt wird, um nach dem Durchlaufen eines Reglers 22 das Ausgangssignal UI zu bilden. UI wird in einem zweiten Mischer 23 ein weiteres Mal mit dem von der PLL 10 bereitgestellten Hilfssignal x_prop gemischt und anschließend einem Summierer 25 invertiert zusammen mit dem noch nicht verstärkten Ausgangssignal des CVGs 3 zugeführt, um das Störsignal QUAD zu eliminieren bzw. wesentlich zu mindern.

Das vorher zu Fig. 1 beschriebene Abgleichverfahren versagt in einer Vorrichtung nach Fig. 2, da der Quadraturregelkreis 20 bei angelegtem Drehratensignal des Sensors 3 und einer fehlabgeglichenen PLL 10 das nach Quadratur demodulierte Drehratensignal am Signalausgang unterdrückt. D. h. es fehlt das Kriterium zum Abgleichen des Phasenwinkels $\alpha$ der PLL 10. Vielmehr muß hier nun ein Signal an einem Ausgang des Reglers 22 als Abgleichkriterium herangezogen werden. An dem Ausgang des Reglers 22 ergeben sich sehr kleine Signale in $V/°(\alpha)$, die sich bei großem Fangbereich des Reglers 22 weiter verkleinern. Diese Problematik kann nicht dadurch umgangen werden, daß das Signal UI am Ausgang des Reglers 22 verstärkt ausgegeben wird, da die zur Verfügung stehende Versorgungsspannung meist, z.B. auf 5V, begrenzt ist, und das zur Unterdrückung der Quadratur notwendige Signal oft wesentlich größer ist, als das durch die Einwirkung einer äußeren Drehrate sich ergebende Signal. Das verstärkte Signal UI würde daher an die Grenzen des möglichen Aussteuerbereiches stoßen.

Nachfolgend werden die einige Verarbeitungsschritte zur Verdeutlichung der auftretenden Probleme und der positiven Auswirkung einer erfindungsgemäßen Lösung in der Form von Gleichungen erläutert:

Unter der Voraussetzung, daß v = konstant und keine wegproportionalen Störsignale (Quadratur Q) vorhanden sind, gilt:

$$U\cdot = \text{konst.1} * \cos(w0*t-\alpha) \ * \ \Omega*\cos(wN*t) \qquad\qquad (1)$$

$$U = 1/2*\text{konst.1}* \ \Omega \ *[\cos((w0-wN)*t-\alpha)+ \cos((w0+wN)*t-\alpha)]$$

wobei:

U : amplitudenmoduliertes drehratenproportionales Signal konst.1: Konstante 1
w0 : Sensorantriebsresonanzfrequenz

$\alpha$ : Phasenverschiebung Detektionsmode Sensorelement
$\Omega$ : äußere Drehrate
wN : Nutzfrequenz bzw. Drehrate
t : Zeitvariable

Wird bei der Synchrondemodulation mit dem Rechtecksignal v_prop vernachlässigt, daß die ungeradzahligen Vielfachen ebenfalls Anteile liefern, so ergibt sich mit

$$v\_prop = \cos(w0*t-\alpha)$$

wobei:

v_prop: geschwindigkeitsproportionales Demodulationssignal

als Ausgangssignal nach Tiefpassfilterung mit Unterdrückung der doppelten Frequenz:

$$\text{RATE OUT} = gvar*konst.1*1/2*\Omega*\cos(wN*t) \tag{2}$$

wobei:

RATE OUT: Ausgangssignal am Drehratensensor

Über g_var kann in dem Verstärker 16 die Sollempfindlichkeit der gesamten Kombination 300 abgeglichen werden.

Sind Quadratursignale Q vorhanden, so verändert sich (1) unter der Annahme, daß die Quadratur ebenfalls um $\alpha$ phasenverschoben wird, zu:

$$U = konst.1 * \cos(w0*t-\alpha) * \Omega * \cos(wN*t)+$$

$$konst.2 * Q * \sin(w0*t-\alpha) \tag{3}$$

wobei:

Gvar :     variable Verstärkung zum Empfindlichkeitsabgleich
Q :         Amplitude der Quadratursignale QUAD
konst.2:   Konstante 2

Würde nun das Demodulationssignal v_prop nicht um $\alpha$ verschoben, so ergäbe sich:

$$\text{RATE OUT} = gvar*konst.1 *1/2* \Omega * \cos(wN*t) * \cos\alpha +$$

$$gvar*konst.2 *1/2* Q * \sin\alpha \tag{4}$$

Aus den Gleichungen (3) und (4) wird ersichtlich, daß der Anteil des Quadratursignals QUAD aus zwei Gründen im Vergleich zum Nutzsignal klein sein muß:

1. Die Signalverarbeitung muß bis zur Synchrondemodulation das Quadratursignal linear verarbeiten können.
2. Bei einer Fehldemodulation mit dem Winkel $\alpha$ ergibt sich am Ausgang ein Offset:

$$\text{RATE OUT} = \text{gvar*konst.2 *1/2* Q * sin}\alpha$$

Es wird daher im System ein Quadraturregelkreis 20 vorgesehen, der das amplitudenmodulierte Signal U nach dem Weg (Quadratur) durch Multiplikation mit x_prop demoduliert, Fig. 2. Dieses Signal wird über einen Regler 22 zugeführt, der einen I-Regler darstellt und das Signal aufintegriert. Nach einer erneuten Modulation mit x_prop wird das Ausgangssignal UI dem von dem Sensorelement 3 kommenden Quadratursignal an dem Summierer 25 "entgegengehalten". Der Summierer 25 regelt den Quadraturanteil der Spannung U bis auf eine sehr kleine, bleibende Regelabweichung auf Null.

Fig. 4 zeigt den bekannten Drehratensensor in detaillierterer Darstellung und die bekannte Auswertungsschaltung gemäß der Fig. 2. Der Übersichtlichkeit halber sind nur die Bezugszeichen der größeren Funktionsblöcke und von Verbindungselementen eingetragen worden, z.B. CVG 3, Auswertungsvorrichtung 8, Quadraturregelkreis 20 etc.

Der Fangbereich des Quadraturregelkreises 20 ergibt sich zu:

$$\Delta\text{UI} = \Delta\text{UIN} = \text{U}_{HF} * \delta C / CQ1,2$$

wobei:

$\text{U}_{HF}$ : Amplitude der trägerfrequenten Meßspannung
$\Delta\text{UI}$ : Änderung I-Reglerausgangsspannung
$\Delta\text{UIN}$ : Eingangsspannung Modulator

d.h. bei gegebenem max. $\Delta\text{UI}$ (z.B. vorgegeben durch den maximalen Bereich der Aussteuerung des Operationsverstärkers) ergibt sich ein max. zulässiges $\delta C_{Quad}$ zu:

$$\delta C_{Quad} = CQ1,2 * \Delta\text{UI} / \text{U}_{HF} \hspace{4cm} (5)$$

wobei:

$\delta C_{Quad}$ : Kapazitätsänderung aufgrund von Quadratur
$CQ1,2$ : Einkoppelkapazitäten des Quadraturregelkreises

Mit $\delta C_{Quad}$ und $\Delta\text{UI}$ sind die Amplituden der entsprechenden Sinusschwingungen gemeint. Aus (5) ist zu erkennen, daß der Quadraturreglerfangbereich durch Vergrößerung von CQ1,2 ebenfalls erweitert werden kann, bzw. für einen geforderten Fangbereich ein minimales CQ1,2 notwendig ist.

Ist die PLL 10 um den Winkel $\alpha$ fehlabgeglichen und legt man für den Abgleich eine konstante äußere Drehrate proportional zu cos(w0*t) an, so wird sich der Reglerausgang in seiner Amplitude so einstellen, daß der Regler kein Eingangssignal erhält.

Es gilt die trigonometrische Gleichung:

$$\delta C * \cos(w0*t-\alpha) = \delta C * [\cos(w0*t)*\cos\alpha + \sin(w0*t)*\sin\alpha]$$

Beim ersten Term der großen Klammer handelt es sich um die Drehrate, die durch den Quadraturregelkreis nahezu unbeeinflußt bleibt (für $\alpha$ < 1°). Der zweite Term ist in Phase zur Quadratur und wird daher vom Quadraturregelkreis erfaßt und unterdrückt.

Für den eingeschwungenen Zustand gilt:

$$\delta C \ * \ \sin(w0*t)*\sin \alpha = CQ1,2* \ \Delta UI/U_{HF} \ *\sin(w0*t), \ bzw.$$

$$\Delta UI = U_{HF} \ * \ \delta C \ / \ CQ1,2 \ * \ \sin \alpha \qquad\qquad (6)$$

Zahlenbeispiel:

Für $U_{HF}$ = 0.8V, CQ1,2 = 0.75pF, $\delta C$ = 2.5fF bei 100°/s und $\alpha$ = 1° folgt $\Delta UI$ = 47 $\mu$V/°, d.h. in den in Fig. 2 und Fig. 4 dargestellten Anordnungen ist am Reglerausgang eine sehr hohe Spannungsänderung von 47 $\mu$V/° bei einer äußeren Drehrate von 100°/s meßbar.

Der Abgleich wird in den Vorrichtungen von Fig. 2 und 4 nach dem Stand der Technik so durchgeführt, daß bei einer angelegten konstanten Drehrate alle Abgleichbits des PLL-Abgleichs angewählt werden und das Ausgangssignal des Reglers 22 aufgezeichnet wird. Der gleiche Vorgang wird bei gleicher Drehrate mit anderem Vorzeichen wiederholt. Der Schnittpunkt beider Kennlinien kennzeichnet die richtige Abgleichkombination. Kleine Abgleichgrößen sind fertigungstechnisch jedoch schlecht zu erfassen. Das Problem kann durch Einsatz eines zusätzlichen Verstärkers verbessert werden. Dies hat jedoch den Nachteil, daß das ohnehin vorhandene Quadratursignal QUAD am Reglerausgang, das sehr viel größer als das Abgleichsignal sein kann, mit verstärkt wird.

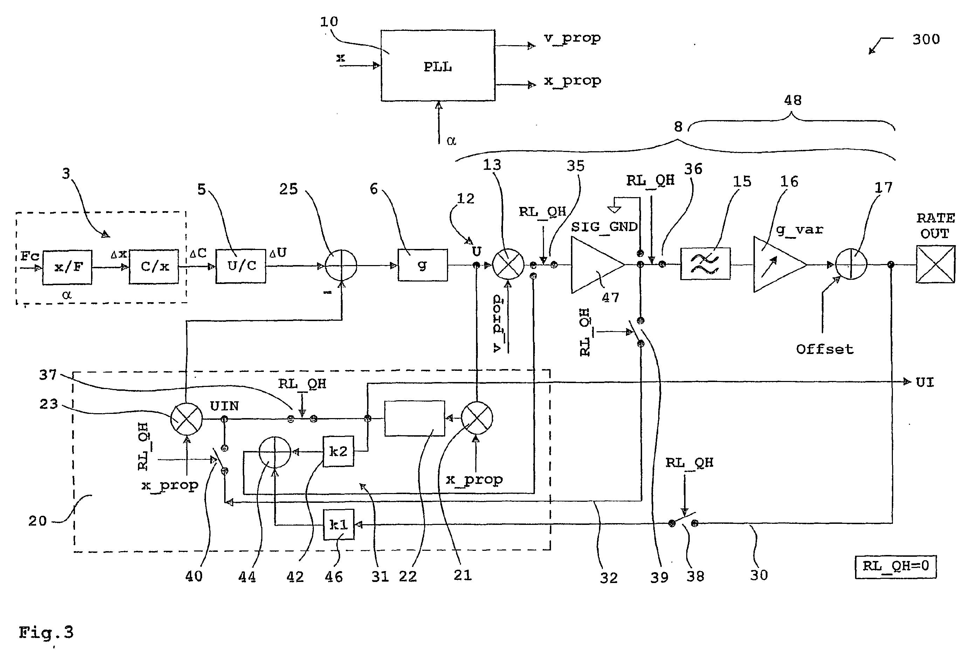

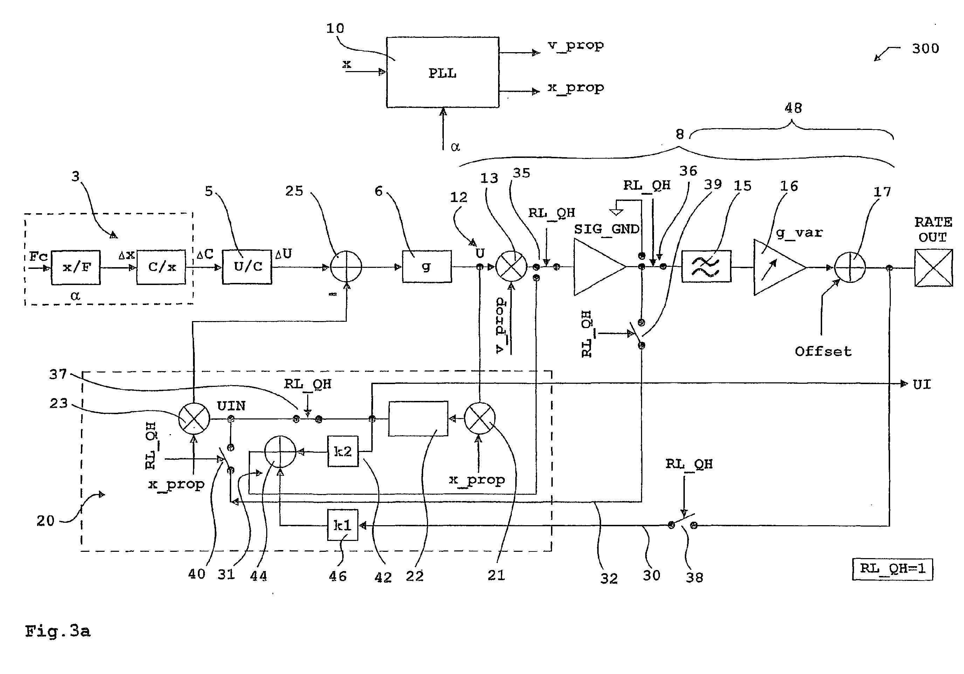

In Fig.3 ist eine erfindungsgemäße Lösung dieses Problems dargestellt. Gegenüber der Schaltung in Fig. 2 sind der Schaltung in Fig. 3 für einen verbesserten Abgleich drei Zweige 30, 31, 32 hinzugefügt worden. Die erweiterte Schaltung der Auswertungsvorrichtung 8 wird über Schalter 35, 36 im Signalpfad 12, einem Schalter 37 im Quadraturregelkreis 20 und je einen Schalter 38, 39 in dem Rückkoppelzweig 30 und dem Verbindungszweig 32 dem nachfolgend beschriebenen Verfahren entsprechend hinzugefügt. Über ein beim Abgleich durch eine Software ansteuerbares FLAG RL_QH kann durch eine logische "1" die Schalterstellung der eingezeichneten Schalter 35, 36, 37, 38, 39 verändert werden. Dadurch wird der Abschwächungszweig bzw. Abstimmungszweig 31 zwischen den Ausgang des Reglers 22 und den Eingang des Verstärkers bzw. Impedanzwandlers 47 geschaltet. Der Abschwächungszweig 31 weist ein Abschwächungsglied 42, das einen Abschwächungsfaktor K2 aufweist, einen Summierer 44, ein Einkoppelglied 46, das über den Rückkoppelzweig 30 das mit einem Faktor K1 gewichtete Ausgangssignal dem Summierer 44 zuführt, und einen Impedanzwandler 47 auf, der zwischen den Ausgang des Summierers 44 und den Eingang des Mischers 23 geschaltet ist. Der Eingang des Einkoppelgliedes 46 ist mit RATE OUT verbunden, es kann in einer alternativen Ausführungsform auch ein separater Eingang dafür vorgesehen sein. Die Schalterstellungen in Fig. 3 sind so gezeichnet, wie sie für RL_QH = 0 gültig sind, d. h. die Schalterstellung im normalen Regelbetrieb. Fig. 3a zeigt ergänzend dazu die Schalterstellungen für RL_QH = 1, also den Abgleichzustand.

Für den Phasenabgleich der PLL 10 und der Auswertungsvorrichtung 8 wird erfindungsgemäß bevorzugt nach folgendem Verfahren vorgegangen:

1. Zunächst wird die Spannung UI am Ausgang des Quadraturreglers 22 für die Schalterstellungen entsprechend RL_QH = 0 ohne Einwirkung einer äußeren Drehrate gemessen und ausgelesen. Damit ist für den abzugleichenden Drehratensensor 3 die Spannung $UI_{Quad}$ ermittelt, die notwendig ist, die vorhandene Quadratur der Sensorvorrichtung 3 wegzuregeln.

2. Mit Setzen von RL_QH = 1 und den entsprechenden Schalterstellungen wird diese Spannung $UI_{Quad}$ über den ohnehin vorhandenen Offset-Abgleich mit RATE OUT an das Einkoppelglied K1 angelegt. Der Signalpfad 12 wird dabei gleichzeitig durch einen Schalter 36 auf Signal_ground bzw. Masse gelegt, um am Signalausgang nur die Auswirkung des Offset-Abgleiches zu haben. Das Signal UI am Ausgang des Reglers 22 stellt sich auf Signal_ ground bzw. Masse ein, d.h. es wird nichts zusätzlich eingespeist, da die für die Unterdrückung der Quadratur notwendige Spannung über das Einkoppelglied K1 bereits zur Verfügung gestellt wird.

3. Legt man jetzt eine äußere Drehrate an, so ändert sich die Reglerausgangsspannung gemäß:

$$\Delta UI = 1/K2 \ * \ U_{HF} \ * \ \delta C/CQ1,2 \ * \ \sin \alpha \qquad\qquad (7)$$

wobei:

$\Delta UI$ : Änderung der Reglerausgangsspannung
K2 : Faktor der Abschwächung

$U_{HF}$ : Amplitude der trägerfrequenten Meßspannung

$\delta C$ : Kapazitätsänderung der Meß-Kapazitäten im Sensorelement

CQ1,2 : Einkoppelkapazitäten des Quadraturregelkreises $\alpha$ : Phasenverschiebung Detektionsmode Sensorelement

Da K2 « 1 gewählt werden kann, läßt sich hierdurch die Abgleichempfindlichkeit signifikant erhöhen. Es wird nun wieder die richtige Abgleichkombination ermittelt, wie vorher unter Bezug auf den Stand der Technik nach Fig. 2 beschrieben wurde.

CQ1,2 darf einen sich aus dem geforderten Quadraturfangbereich ergebenden minimalen Wert nicht unterschreiten, daher kann die Abgleichempfindlichkeit auch über 1/K2 » 1 bei gegebenem $U_{HF}$ und $\delta C$ vergrößert werden.

4. Nach dem Abgleich wird RL_QH = 0 durch die Software gesetzt und die Schalter nehmen die in Fig. 3 gezeigte Schalterstellung ein .

Die Einstellung der Abgleichempfindlichkeit ist somit von der des Quadraturfangbereichs entkoppelt und mit wesentlich verbesserter Genauigkeit durchgeführt worden. Zum Abschluß des Verfahrens, das beispielsweise durch eine geeignete Software auch vollautomatisch durchgeführt werden kann, ist der normale Regelbetrieb in der abgestimmten Regeleinrichtung eingestellt.

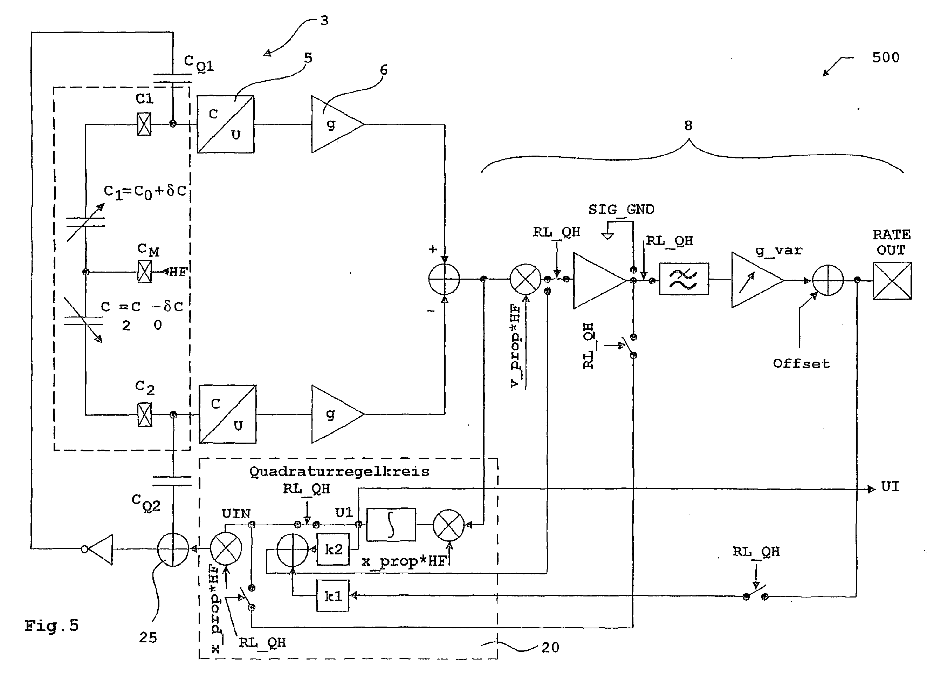

Fig. 4 zeigt eine Kombination 400 aus dem bekannten Drehratensensor 3, der ggü. Fig. 1 detaillierter dargestellt ist, und der bekannten Auswertungsschaltung 8 gemäß Fig. 2. Fig. 5 zeigt eine Kombination 500 aus dem bekannten Drehratensensor 3, der ggü. Fig. 1 detaillierter dargestellt ist, und der erfindungsgemäßen Auswertungsvorrichtung bzw. Auswertungsschaltung gemäß Fig. 3. Der Übersichtlichkeit halber sind in den Figuren 4 und 5 lediglich die Bezugszeichen der größeren Funktionblöcke der Figuren 2 und 3 angegeben. Für die Durchführung des erfindungsgemäßen Verfahrens ist es unerheblich, daß zur Auswertung der Kapazitätsänderung der Kapazitäten C1 = $C_0$ + $\delta C$ und C2 = $C_0$ - $\delta C$ des Drehratensensors 3, infolge der Einwirkung einer δußeren Drehrate auf die oszillierende Masse des Sensors, eine hochfrequente Spannung $U_{HF}$ verwendet wird, wie in den Figuren 4 und 5 angegeben.

Bei einer erfindungsgemäßen Weiterbildung wird die erforderliche Quadraturspannung über einen separaten Pin bzw. Anschluß von extern an das Einkoppelglied K1 angelegt (nicht dargestellt).

## Patentansprüche

**1.** Verfahren zum Abgleichen des Phasenregelkreises (10) einer elektronischen Auswertungsvorrichtung (8), die das Ausgangssignal einer Sensorvorrichtung (3) auswertet, insbesondere ein den Coriolis-Effekt nutzender Drehratensensor mit einer oszillierenden Masse, die bei der Einwirkung einer äußeren Drehrate auf die Sensorvorrichtung eine Auslenkung ($\Delta x$) erfährt und das Ausgangssignal ein Drehratensignal darstellt, wobei die elektronische Auswertungsvorrichtung (8) neben dem Phasenregelkreis (10) einen Regelkreis (20), wie insbesondere ein Quadraturregelkreis, aufweist und der Regelkreis mit einem Regler (22), der einen Eingang und einen Ausgang aufweist, sowie mit einem einen Eingang aufweisenden Modulator bzw. Mischer (23) versehen ist, dessen Eingang mit dem Ausgang des Reglers (22) in einer ersten elektrischen Verbindung steht, **dadurch gekennzeichnet, dass** die erste elektrische Verbindung (RL_QH=0) zwischen dem Ausgang des Reglers (22) und dem Eingang des Mischers (23) getrennt, und eine zweite elektrische Verbindung (RL_QH=1) zwischen dem Ausgang des Reglers (22) und dem Eingang des Mischers (23) herbeigeführt wird, wobei die zweite elektrische Verbindung unter Zwischenschaltung eines Abschwächungsglieds (42) erfolgt.

**2.** Verfahren nach Anspruch 1, **dadurch gekennzeichnet, dass** der Faktor der Abschwächung (K2) des Abschwächungsglieds (42) kleiner als 1, vorzugsweise K2 << 1, gewählt wird, wodurch die Abgleichempfindlichkeit des Ausgangs des Reglers (22) deutlich gegenüber dem Fall erhöht wird, in dem der Faktor der Abschwächung den Wert 1, d. h. K2 = 1, ist.

**3.** Verfahren nach Anspruch 1 oder 2, **dadurch gekennzeichnet, dass** die zweite elektrische Verbindung unter Zwischenschaltung eines Summierers (44) erfolgt.

**4.** Verfahren nach einem der Ansprüche 1 bis 3, **dadurch gekennzeichnet, dass** für den Abgleich des Phasenregelkreises (10) in einem ersten Schritt die erste elektrische Verbindung (RL_QH=0) herbeigeführt und die Ausgangsspannung des Reglers (22) des Regelkreises bzw. Quadraturregelkreises (20), ohne die Einwirkung einer äußeren Drehrate auf die Sensorvorrichtung (3), ermittelt wird.

5.  Verfahren nach Anspruch 4, **dadurch gekennzeichnet, dass** für den Abgleich des Phasenregelkreises (10) in einem zweiten Schritt die zweite elektrische Verbindung (RL_QH=1) herbeigeführt wird.

6.  Verfahren nach Anspruch 5, **dadurch gekennzeichnet, dass** die Auswertungsvorrichtung (8) eine Ausgangsstufe (48) aufweist und diese während des zweiten Schritts an Signal-Masse (SIG_GND) gelegt wird.

7.  Verfahren nach Anspruch 6, **dadurch gekennzeichnet, dass** sich das Spannungsniveau des Ausgangs des Reglers (22) während des zweiten Schritts (RL_QH=0) auf das Spannungsniveau der Signal-Masse einstellt, wobei über den Summierer (17) der Ausgangsstufe (48) dem Summierer (44) des Regelkreises (20) eine Spannung zugeführt wird, die proportional zu der im ersten Schritt ermittelten Ausgangsspannung des Reglers (22) des Regelkreises (20) ist.

8.  Verfahren nach Anspruch 7, **dadurch gekennzeichnet, dass** in einem dritten Schritt eine äußere Drehrate auf die Sensorvorrichtung (3) einwirkt.

9.  Verfahren nach einem der Ansprüche 1 bis 8, **dadurch gekennzeichnet, dass** bei der Einwirkung einer äußeren Drehrate für die Ausgangsspannung des Reglers (22) gilt:

$$\Delta UI = I/K2 * U_{HF} * \delta C/CQ1,2 * \sin \alpha \qquad\qquad (7)$$

wobei:

    $\Delta UI$ : Änderung der Reglerausgangsspannung
    K2 : Faktor der Abschwächung
    $U_{HF}$ : Amplitude der trägerfrequenten Messspannung
    $\delta C$ : Kapazitätsänderung der Mess-Kapazitäten im Sensorelement
    CQ1,2 : Einkoppelkapazitäten des Quadraturregelkreises
    $\alpha$ : Phasenverschiebung Detektionsmode Sensorelement

10. Elektronische Auswertungsvorrichtung (8) zur Messung des Ausgangssignals einer Sensorvorrichtung (3), insbesondere ein den Coriolis-Effekt nutzender Drehratensensor mit einer oszillierenden Masse, die bei der Einwirkung einer äußeren Drehrate auf die Sensorvorrichtung (3) eine Auslenkung ($\Delta x$) erfährt und das Ausgangssignal ein Drehratensignal darstellt, wobei die elektronische Auswertungsvorrichtung (8) einen Phasenregelkreis (10) und einen Regelkreis, wie insbesondere ein Quadraturregelkreis (20), aufweiset, der mit einem Regler (22), der einen Eingang und einen Ausgang aufweist, sowie mit einem einen Eingang aufweisenden Modulator bzw. Mischer (23) versehen ist, **dadurch gekennzeichnet, dass** der Regelkreis (20) ein Abschwächungsglied (42) und vorzugsweise auch einen Summierer (44) und/oder ein Einkoppelglied (K1) aufweist.

**Claims**

1.  Method for adjusting the phase locked loop (10) of an electronic evaluation device (8) which evaluates the output signal from a sensor device (3), in particular a rate of rotation sensor which uses the Coriolis effect and has an oscillating mass which undergoes a deflection ($\Delta x$) when an external rate of rotation acts on the sensor device, and the output signal represents a rate of rotation signal, the electronic evaluation device (8) having, in addition to the phase locked loop (10), a control loop (20) such as, in particular, a quadature control loop, and the control loop being provided with a controller (22), which has an input and an output, and with a modulator or mixer (23) which has an input and the input of which has a first electrical connection to the output of the controller (22), **characterized in that** the first electrical connection (RL_QH=0) between the output of the controller (22) and the input of the mixer (23) is disconnected and a second electrical connection (RL_QH=1) is established between the output of the controller (22) and the input of the mixer (23), the second electrical connection being effected with the interposition of an attenuator (42).

2.  Method according to Claim 1, **characterized in that** the attenuation factor (K2) of the attenuator (42) is selected to be less than 1, preferably K2 << 1, as a result of which the adjustment sensitivity of the output of the controller (22) is increased considerably in comparison with the case in which the attenuation factor has the value 1, that is to say K2 = 1.

3. Method according to Claim 1 or 2, **characterized in that** the second electrical connection is effected with the interposition of an adder (44).

4. Method according to one of Claims 1 to 3, **characterized in that**, in order to adjust the phase locked loop (10), the first electrical connection (RL_QH=0) is established in a first step and the output voltage of the controller (22) of the control loop or quadature control loop (20) is determined without an external rate of rotation acting on the sensor device (3).

5. Method according to Claim 4, **characterized in that**, in order to adjust the phase locked loop (10), the second electrical connection (RL_QH=1) is established in a second step.

6. Method according to Claim 5, **characterized in that** the evaluation device (8) has an output stage (48) and the latter is connected to signal earth (SIG_GND) during the second step.

7. Method according to Claim 6, **characterized in that** the voltage level of the output of the controller (22) is adapted to the voltage level of signal earth during the second step (RL_QH=0), a voltage which is proportional to that output voltage of the controller (22) of the control loop (20) which is determined in the first step being supplied to the adder (44) of the control loop (20) via the adder (17) of the output stage (48).

8. Method according to Claim 7, **characterized in that** an external rate of rotation acts on the sensor device (3) in a third step.

9. Method according to one of Claims 1 to 8, **characterized in that**, when an external rate of rotation has an effect, the following applies to the output voltage of the controller (22):

$$\Delta UI = 1/K2 * U_{HF} * \delta C/CQ1,2 * \sin \alpha \qquad (7)$$

where:

$\Delta$UI: change in the controller output voltage
K2: attenuation factor
$U_{HF}$: amplitude of the carrier-frequency measurement voltage
$\delta$C: change in the capacitance of the measuring capacitances in the sensor element
CQ1,2: coupling-in capacitances of the quadrature control loop
$\alpha$: phase shift in the detection mode of the sensor element.

10. Electronic evaluation device (8) for measuring the output signal from a sensor device (3), in particular a rate of rotation sensor which uses the Coriolis effect and has an oscillating mass which undergoes a deflection ($\Delta$x) when an external rate of rotation acts on the sensor device (3), and the output signal represents a rate of rotation signal, the electronic evaluation device (8) having a phase locked loop (10) and a control loop such as, in particular, a quadature control loop (20) which is provided with a controller (22), which has an input and an output, and with a modulator or mixer (23) which has an input, **characterized in that** the control loop (20) has an attenuator (42) and preferably also has an adder (44) and/or a coupling-in element (K1).

**Revendications**

1. Procédé pour équilibrer le circuit de régulation de phase (10) d'un dispositif d'analyse électronique (8) qui analyse le signal de sortie d'un dispositif de détection (3), notamment d'un détecteur de fréquence de rotation employant l'effet Coriolis avec une masse oscillante, laquelle subit une déviation ($\Delta$x) lorsqu'une fréquence de rotation externe agit sur le dispositif de détection et le signal de sortie représente un signal de fréquence de rotation, le dispositif d'analyse électronique (8), outre le circuit de régulation de phase (10), présentant un circuit de régulation (20) comme notamment un circuit de régulation en quadrature, et le circuit de régulation étant doté d'un régulateur (22), qui présente une entrée et une sortie, ainsi que d'un modulateur ou un mélangeur (23) qui présente une entrée, ladite entrée étant reliée à la sortie du régulateur (22) dans une première liaison électrique, **caractérisé en ce que** la première liaison électrique (RL_QH = 0) entre la sortie du régulateur (22) et l'entrée du mélangeur (23) est déconnectée et une deuxième liaison électrique (RL_QH = 1) est établie entre la sortie du régulateur (22) et l'entrée du mélangeur (23), la deuxième liaison électrique étant réalisée en intercalant un élément d'affaiblissement (42).

2.  Procédé selon la revendication 1, **caractérisé en ce que** le facteur d'affaiblissement (K2) de l'élément d'affaiblissement (42) est choisi inférieur à 1, de préférence K2 << 1, ce qui accroît considérablement la sensibilité d'équilibrage de la sortie du régulateur (22) par rapport au cas dans lequel le facteur d'affaiblissement a pour valeur 1, c'est-à-dire lorsque K2 = 1.

3.  Procédé selon la revendication 1 ou 2, **caractérisé en ce que** la deuxième liaison électrique est réalisée en intercalant un additionneur (44).

4.  Procédé selon l'une des revendications 1 à 3, **caractérisé en ce que** pour l'équilibrage du circuit de régulation de phase (10), une première étape consiste à établir la première liaison électrique (RL_QH = 0) et à déterminer la tension de sortie du régulateur (22) du circuit de régulation ou du circuit de régulation en quadrature (20) en l'absence d'une fréquence de rotation externe qui agit sur le dispositif de détection (3).

5.  Procédé selon la revendication 4, **caractérisé en ce que** pour l'équilibrage du circuit de régulation de phase (10), une deuxième étape consiste à établir la deuxième liaison électrique (RL_QH = 1).

6.  Procédé selon la revendication 5, **caractérisé en ce que** le dispositif d'analyse (8) présente un étage de sortie (48) et celui-ci est mis à la masse du signal (SIG_GND) pendant la deuxième étape.

7.  Procédé selon la revendication 6, **caractérisé en ce que** pendant la deuxième étape (RL_QH = 0), le niveau de tension de la sortie du régulateur (22) se règle au niveau de tension de la masse du signal, une tension étant acheminée à l'additionneur (44) du circuit de régulation (20) par le biais de l'additionneur (17) de l'étage de sortie (48), laquelle est proportionnelle à la tension de sortie du régulateur (22) du circuit de régulation (20) déterminée à la première étape.

8.  Procédé selon la revendication 7, **caractérisé en ce que** dans une troisième étape, une fréquence de rotation externe agit sur le dispositif de détection (3).

9.  Procédé selon l'une des revendications 1 à 8, **caractérisé en ce que** l'équation suivante est vérifiée pour la tension de sortie du régulateur (22) en présence d'un fréquence de rotation externe qui agit :

$$\Delta UI = I/K2 * U_{HF} * \delta C/CQ1,2 * \sin \alpha \qquad\qquad (7)$$

où :

$\Delta UI$ désigne la variation de la tension de sortie du régulateur
K2 désigne le facteur d'affaiblissement
$U_{HF}$ désigne l'amplitude de la tension de mesure à la fréquence porteuse
$\delta C$ désigne la variation de capacité des capacités de mesure dans l'élément de détection
CQ1,2 désigne les capacités de découplage du circuit de régulation en quadrature
$\alpha$ désigne le déphasage du mode de détection de l'élément de détection.

10. Dispositif d'analyse électronique (8) pour mesurer le signal de sortie d'un dispositif de détection (3), notamment d'un détecteur de fréquence de rotation employant l'effet Coriolis avec une masse oscillante, laquelle subit une déviation ($\Delta x$) lorsqu'une fréquence de rotation externe agit sur le dispositif de détection (3) et le signal de sortie représente un signal de fréquence de rotation, le dispositif d'analyse électronique (8) présentant un circuit de régulation de phase (10) et un circuit de régulation, comme notamment un circuit de régulation en quadrature (20), et étant muni d'un régulateur (22), qui présente une entrée et une sortie, ainsi que d'un modulateur ou d'un mélangeur (23) qui présente une entrée, **caractérisé en ce que** le circuit de régulation (20) présente un élément d'affaiblissement (42) et de préférence aussi un additionneur (44) et/ou un élément de découplage (K1).

Fig.1 (Stand der Technik)

Fig.2 (Stand der Technik)

Fig.3

Fig. 3a

Fig.4 (Stand der Technik)

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6067858 A
- US 5600064 A